Europäisches Patentamt

European Patent Office

Office européen des brevets

(19)

(11) Publication number: **0 065 599**
**B1**

(12) # EUROPEAN PATENT SPECIFICATION

(45) Date of publication of patent specification: **29.01.86**

(21) Application number: **81302215.9**

(22) Date of filing: **19.05.81**

(51) Int. Cl.⁴: **H 01 L 27/14,** H 01 L 31/02, H 04 N 5/33

(54) **Infrared imaging system with infrared detector matrix, and method of imaging infrared energy.**

(43) Date of publication of application:
**01.12.82 Bulletin 82/48**

(45) Publication of the grant of the patent:
**29.01.86 Bulletin 86/05**

(84) Designated Contracting States:
**DE FR GB IT**

(56) References cited:
**DE-A-2 842 346**
**GB-A-1 569 574**
**US-A-3 676 590**
**US-A-3 912 927**
**US-A-3 979 604**
**US-A-4 231 149**

**IEEE TRANSACTIONS ON ELECTRON
DEVICES, vol. ED-27, no. 1, January 1980, New
York, r.A. CHAPMAN "Monolithic HgCdTe
charge transfer device infrared imaging
arrays", pages 134-145**

(73) Proprietor: **TEXAS INSTRUMENTS
INCORPORATED**
**13500 North Central Expressway**
**Dallas Texas 75265 (US)**

(72) Inventor: **Chapman, Richard A.**
**7240 Briarcove Drive**
**Dallas Texas (US)**

(74) Representative: **Abbott, David John et al**
**Abel & Imray Northumberland House 303-306**
**High Holborn**
**London, WC1V 7LH (GB)**

(56) References cited:
**IEEE TRANSACTIONS ON ELECTRON
DEVICES, vol. ED-27, no. 1, January 1980, New
York, r.D. THOM "A fully monolithic InSb
infrared CCD array", pages 160-170**

**IEEE TRANSACTIONS ON ELECTRON
DEVICES, vol. ED-27, no. 1, January 1980, New
York, H. TAKIGAWA "Hybrid IRCCD imaging
array", pages 146-149**

## Description

This invention relates to infrared imaging systems and more particularly to an infrared imaging system having an infrared detector matrix utilizing transfer gates.

In the past, infrared detector systems have been of two types staring and non-staring. Staring systems do not require a scanning assembly; while non-staring systems have scanning assemblies. Further, prior art infrared detector systems were transducer type; that is, the impinging infrared energy generated a charge which could be collected and integrated over several frames. The integrated signals were preamplified to provide working signals for video processing. The system is relatively expensive, bulky in size, and inefficient in performance.

Published British Patent Application No. 2 007 937A discloses a solid state charge coupled device image sensor having sensor regions of a semiconductor substrate disposed in rows and columns. Electrical charges are transferred from the sensor regions of each column to an associated shift register enabling an electrical signal output to be produced.

United States Patent Specification No 4 231 149 discloses a charge coupled infrared imaging device including a substrate of an infrared sensitive semiconductor, mercury cadmium telluride constructed to act as a charge transfer device to provide an electrical signal output.

Accordingly it is an object of this invention to provide an improved infrared energy imaging system.

Briefly stated the infrared imaging system comprises an optical assembly, a scanning assembly, an infrared detector matrix, and a video signal processor. If the system is a staring system, the scanning assembly is omitted. The optical assembly focuses infrared energy emanating from a scene in its field of view along an optical path where it is scanned by the scanning assembly and the scanned infrared energy impinged onto the infrared detector matrix. The infrared detector matrix is a random access imager (RAI) which converts the impinging infrared energy to representative charge packets which are processed into video signals by the video signal processor.

According to one aspect of the present invention there is provided an infrared imaging system comprising a random access imager including a scan generator, a semiconductor substrate of one conductivity type having a plurality of detector elements for receiving infrared energy and storing charges representative of the impinging infrared energy, said detector elements being arranged in rows and columns and operatively connected to the scan generator, output collector means, each of which comprises a read line which is continuous along its length and connected to each of the detector elements in a column for selectively collecting the charges of the detector elements and circuit means connected to said output collector means for determining the quantity of charge representative of the infrared energy impinging on the detector element; and a signal processing means for processing the electrical energy representative of the infrared energy emanating from a scene into video signals, characterized in that the imaging system comprises a lens system for focussing infrared energy emanating from a scene, the random access imager detector elements and output collector means further comprise a first level of electrodes and a first insulating layer sandwiched between the substrate and the first level electrodes, said first level electrodes defining the detector areas and output collector means, a second layer of insulating material covering the first layer of insulating material and the first level electrodes, second level electrodes formed on the second insulator layer for the detector elements, a third insulator layer formed over the second insulator layer and the second level electrodes, and third level electrodes selectively interconnecting the output collector to columns of detector elements.

According to a second aspect of the present invention there is provided an infrared imaging system comprising, a random access imager including a scan generator, a semiconductor substrate having a plurality of detector elements for receiving infrared energy and storing charges representative of the impinging infrared energy, said detector elements being arranged in rows and columns and operatively connected to the scan generator, output collector means, each of which comprises a read line which is continuous along its length and connected to each of the detector elements of a column for selectively collecting the charges of the detector elements; circuit means connected to said output collector means for determining the quantity of charge representative of the infrared energy impinging on the detector element; and a signal processing means for processing the electrical energy representative of the infrared energy emanating from a scene into video signals; characterized in that the imaging system comprises a lens system for focussing infrared energy emanating from a scene, the output collector means comprises p—n junction regions in the semiconductor substrate and the imager includes a first layer of insulating material covering the substrate, first level electrodes formed on the first insulating area forming a field plate channel stop, a second insulating layer covering the first level electrodes and the first insulating layer, electrodes transparent to infrared energy formed on the second insulating layer, said electrodes defining the MIS detector element areas, leads formed on the second insulating layer selectively connecting the transparent electrodes, a third insulation layer formed over the transparent electrode leads, and second insulator layer, and transfer gate electrodes formed on the third insulation layer over the p—n regions for selectively interconnecting the detector elements to the output collector means.

The preferred features of this invention are set forth in the appended claims. The invention itself, however, as well as other objects and advantages thereof may best be understood by reference to the following detailed description of illustrative embodiments when read in conjunction with the accompanying drawings in which:

Figure 1 is a block diagram of a forward looking infrared system;

Figure 2a is a plan view of the random access imager (RAI);

Figure 2b is a partial plan view of the RAI of Figure 2a with the transfer gate/guard ring metalization removed to show more clearly the detector elements metalization and connecting buses;

Figure 2c is a partial plan view of the RAI of Figure 2b with detector elements metalization and connecting buses removed to show more clearly the field plate/channel stop metalization over the insulator, semiconductor substrate;

Figure 3a is a cross-sectional view taken along line A—A of Figure 2a;

Figure 3b is a cross-sectional view taken along line A—A of Figure 2a modified to show another embodiment of the read out line;

Figure 4 is a cross-sectional view taken along line B—B of Figure 2a;

Figure 5 is a partial top view of the random access imager showing a second embodiment of the read out line and output diode;

Figure 6 is a cross-sectional view taken along line B—B of Figure 5 to show the second embodiment of the read out structure extended to show the read line of B—B Figure 2a;

Figures 7a and 7b are block diagrams of the circuitry necessary for an RAI array without ramping and with ramping, respectively;

Figure 8 shows the output circuitry for each output diode of the RAI array;

Figures 9a, 9b, and 9c show, respectively, the timing and address waveforms for the diode and MIS charge collector means without ramping; and MIS charge collector means with ramping; and

Figures 10a and 10b show, respectively, the filling of potential wells without ramping and with ramping over identical integration times.

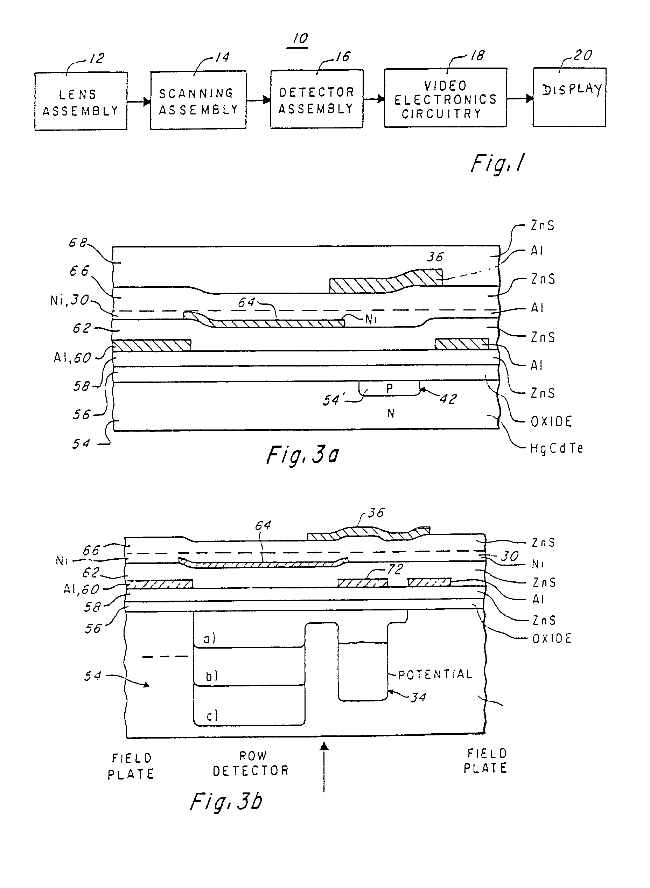

Referring now to the drawings, the forward looking infrared (FLIR) imager (Fig. 1) comprises a lens assembly 12, scanning assembly 14, detector assembly 16, video electronic circuitry 18, and a display 20. In a staring system, the scanning assembly 14 is omitted. The lens system 12 is comprised of three lens elements, not shown, which for operation in the infrared region are germanium elements. These elements collect infrared energy emanating from a scene and focus this energy onto a rotating mirror, not shown, of the scanning assembly 14. The rotating mirror may be, for example, a two sided flat mirror. The first side or front surface, of the mirror is used to receive the infrared energy, and the second side, or rear surface, is used to scan the modulated visible light from the light source. The scanning mirror is positioned with its "Y" axis normal to the optical axis and its "X" axis at a 45 angle thereto. In this position, the scanning mirror reflects the infrared energy to a folding mirror, not shown, for reflections onto the detector matrix of the detector assembly 16. The video electronics circuitry 18 connects each output of the detector array to a light emitting diode, for example, of the light source 20, and provides the signal processing auxiliary functions to modulate the output of each light emitting diode. Finally, the visible light from the light source is directed to impinge upon a folding mirror, not shown, and the folding mirror reflects the visible light through a collimating lens to the second side, or back surface, of the scanning mirror for viewing by an observer. It will be appreciated that the output of the detector matrix might be processed by the video electronics circuitry into a TV format for display on a cathode ray tube. Those desiring details of suitable structures for these assemblies, except the detector matrix to be described hereinafter, are referred to U.S. Patent No. 3,912,927 issued October 14, 1975, to Richart G. Hoffman, II, for an "Opto-Mechanical Device For Phase Shift Compensation of Oscillating Mirror Scanners".

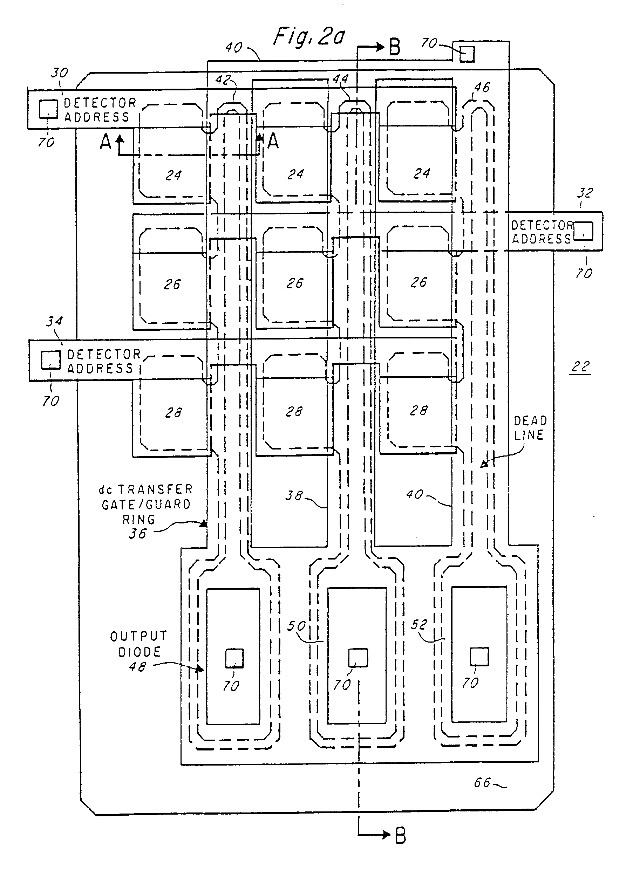

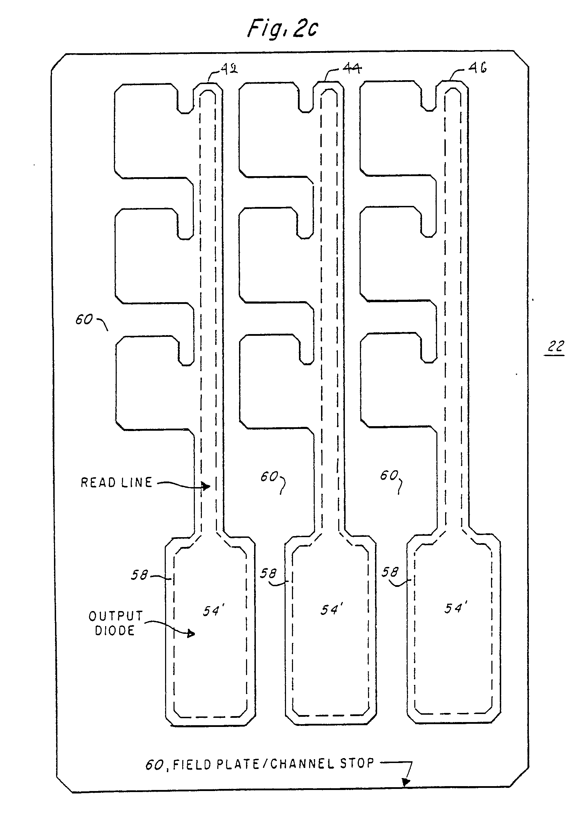

Referring now to Figure 2a, the random access imager (RAI) 22 comprises a 3×3 detector matrix. A 3×3 detector matrix is disclosed for description purposes only; a 64×64 element matrix array is, for example, a more practical design. The detector elements are arranged in rows and columns; the rows of elements being designated, respectively, 24, 26, and 28. The rows of detector elements 24, 26, and 28, are addressed, respectively, through detector address busses 30, 32, and 34. The columns of detector elements 24, 26 and 28 are connected by transfer gates 36, 38, and 40, respectively, to read lines 42, 44, and 46. The read lines 42, 44, and 46 are connected, respectively, to the output collectors 48, 50, and 52.

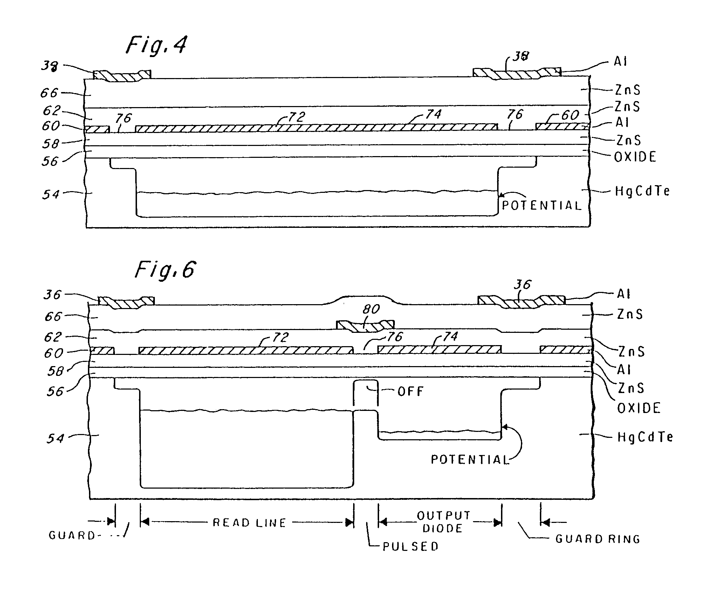

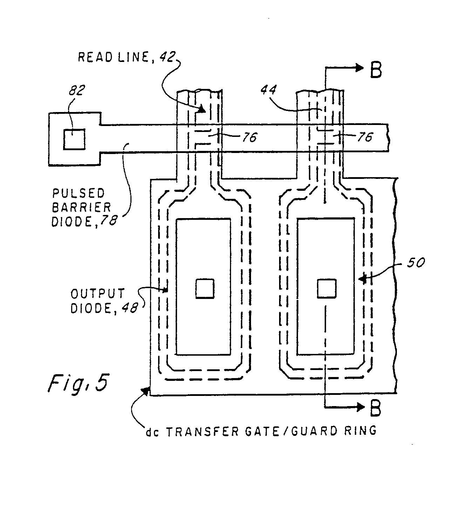

Referring now to Figure 3a which is a cross section of one detector and adjoining read line taken along line A—A of Figure 2a. In the first embodiment of the RAI 22 (Fig. 2a) the rows of detector elements 24, 26 and 28 and transfer gates 36, 38 and 40 are metal/insulator/semiconductor (MIS) structures and the read lines 42, 42, 46, and output collectors 48, 50 and 52 are p—n junctions. In this embodiment, either a p-type or n-type conductivity semiconductor material may be used for a substrate 54 (Fig. 3a). The particular material used depends on the infrared wavelength to be detected. For example, silicon may be used for the visible 1.1 micron wavelength and mercury/cadmium/Telluride may be used for either the 3—5 micron wavelength or 8—14 micron wavelength bands. The bandgap of the material is the determining factor. As shown in Figures 3a and 2c, the substrate 54 is of n-type Hg—Cd—Te. The p—n junction read line 42 is formed, for example, by forming a native oxide layer 56 of a thickness between about 500A 700A (50—70 nanometres) on the HgCdTe substrate 54. The oxide is formed by anodization. The oxide layer 56 is patterned and a via (aperture) etched therein using a lactic acid. The junction is then formed by ion implantation, or impurity diffusion, or mercury in-or-out diffusion to form the p-type conductivity region 54'. The oxide may be left on after junction formation or stripped off, reoxidized, and the via recut using previously etched alignment marks in the substrate. A thin metal layer, not shown, can be deposited directly on the via to the junction before proceeding with the MIS electrode fabrication. The metal layer forms a via etch stop in the final via etch through a ZnS insulation layer.

After the p—n junction is formed, a 500A to 1500A (50—150 nanometres) thick layer 58 of insulating material, such as, for example, ZnS is thermally evaporated on top of the native oxide layer 56. The ZnS layer 58 is then masked and the field plate/channel stop MIS electrode 60 which is, for example, a thick (200A—1500A) (20—150 nanometres) aluminum or nickel electrode patterned on the ZnS layer 58. The electrode 60 is preferably formed using the photolithographic lift process. The device as described to this point is shown in Figure 2c.

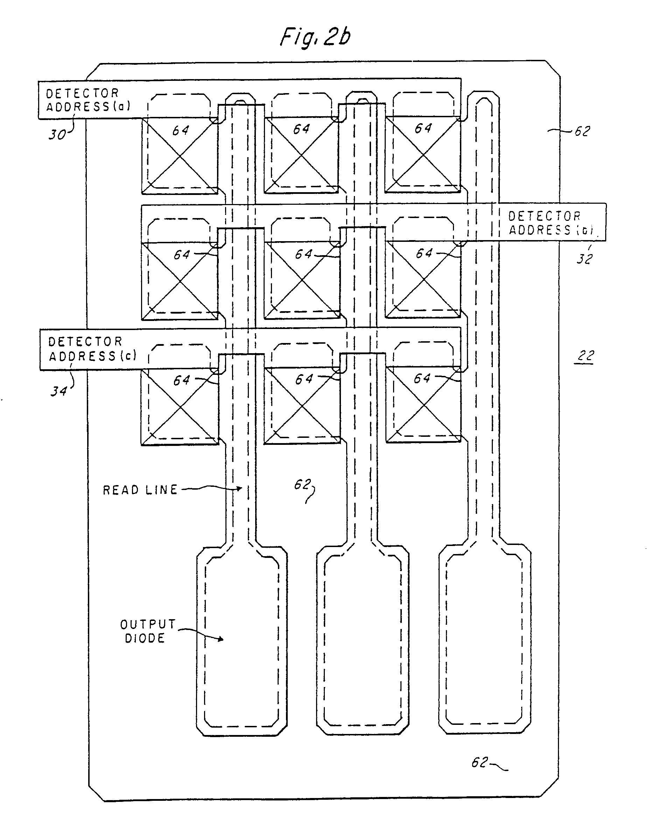

The channel stop MIS structure formed by the substrate 4, insulation layer 58 and channel stop electrode (first level electrode) 60 is covered by a second insulating layer 62 of a thickness between 300Å—500Å (30—50 nanometres) (Fig. 3a). The layer 62 is preferably ZnS. The second insulating layer 62 is then first metallized, using the photolithographic lift process or a chemical etch to form the thin (150) (15 nanometres) semitransparent electrode 64 for each of the rows of detector elements 24, 26 and 28 (Fig. 2b). The thin electrodes are preferably nickel electrodes. The second insulating layer 62 is then metalized again (Fig. 3a) using the photolithographic process to form the thick (200Å—2000Å) (20—200 nano-metres) opaque metal (aluminum) address lines 30, 32 and 34 (Fig. 2b). The aluminum address lines 30, 32, and 34 overlap the thin nickel electrodes 64 to electrically connect the rows of detector elements 24, 26 and 28 (Fig. 2b) to the address lines 30, 32 and 34.

Next, a third layer 66 (Fig. 3a) of insulating material (ZnS) is deposited to a thickness between 1000Å to 3000Å (100—300 nanometres) over the metalizations, and then the opaque transfer gate 36, is formed using the photolithographic lift process, to provide the thick (1000Å—5000Å) (100—500 nanometres) aluminum electrodes 36, 38 and 40 (Fig. 2c). Finally, an additional layer 68 (Fig. 3a) (1000Å—5000Å) (100—500 nanometres) of insulating material (ZnS) is deposited and vias 70 (Fig. 2a) etched to all electrodes and to substrate. A soft bonding material such as, for example, indium is used to form bonding pads and expanded contacts touch the desired electrodes through the vias. In a p—n junction read line, a connection is not required; as it is reset much as a floating source for a MOSFET is reset.

In a second embodiment (Fig. 3b), which is a cross-section taken along line A—A of Figure 2a, the random access imager is a metal-insulator-semiconductor (MIS) structure throughout. That is, the read lines 42, 44 and 46 and output collectors 48, 50 and 52 are MIS structures. The structure is identical to that of Figure 3a except in the MIS embodiment the n-type HgCdTe substrate 54 is anodized to form the native oxide layer 56. An insulation layer 58 of ZnS is formed over the native oxide layer 56, and the field plate/channel stop 60 and read line electrode 72 of read lines 42, 44 and 46 (Fig. 2a) are formed on the ZnS layer 58 (Fig. 3b). The electrode 72 replaces the p—n junction read line of Figure 3a. To complete the structure, the second ZnS insulating layer 62 covers the field plate/channel stop 60 and read line electrode 72 supported by the first ZnS layer 62. The detector element thin electrode 64 and bus 30 are formed on the second ZnS insulating layer and covered by the third ZnS layer 66. The third electrode or dc transfer gate 36 is formed on the third ZnS insulating layer 66. The transfer gate 36 provides the guard ring separating the detector element from the read line.

The MIS structure is also shown in Figure 4, which is a cross section taken along line B—B, Figure 2a. In this structure, the HgCdTe substrate 54 supports the native oxide layer 56 and ZnS insulation layer 58. The field plate/channel stop electrode 60 and read line electrode 72 which is contiguous with output collector electrode 74 are metalized on the insulator layer 58 and form the first electrode area. The first level metalization is covered by insulation (ZnS) layers 62 and 66; layer 66 supports the transfer gate 38. The transfer gate electrode 38 covers the space 76 around the read line and output collector to serve also as a guard ring electrode.

The contiguous read lines 42, 44 and 46 and output collectors 48, 50 and 52 (Fig. 2a), in another embodiment (Fig. 5) are formed in a spaced relationship by gaps 76 and a pulsed barrier switch 78 utilized to control charge flow through the gaps. This embodiment (Fig. 6), which is an MIS structure, includes the HgCdTe 54 substrate supporting the native oxide layer 56 and ZnS insulating layer 58, and the first level metalization formed on the insulation layer 58. The first level metalization includes the field plate/channel stop 60, read line electrode 72 and output collector electrode 74. The read line electrode 72 and output collector electrode 74 are spaced apart to form the gap 76. The first level electrodes are covered by the ZnS insulator layer 62, and the barrier diode electrode 80 is formed on the ZnS layer 62 over the gap 76. The ZnS insulator layer 66 covers the barrier diode electrode 80 and the transfer gate 36 is formed on the ZnS insulator layer 66. A via (Fig. 5) is etched through the ZnS layer 66 and an indium contact formed therein for electrical connection.

The use of the pulsed barrier diode switch 78 makes possible a p—n junction read line and MIS output diode, or an MIS read line and p—n junction output diode.

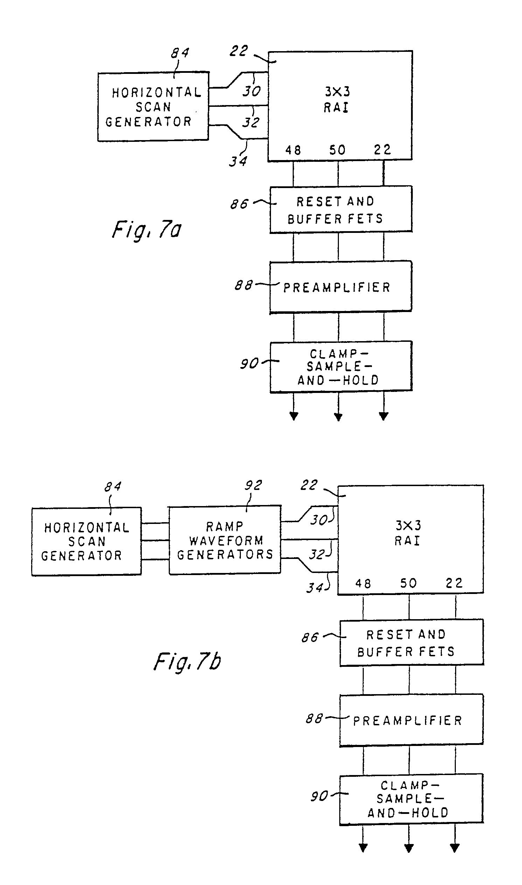

The random access imager (RAI) may be operated in a non-ramped mode or in a ramped mode. In the non-ramped mode, the RAI (Fig. 7a) includes a horizontal scan generator 84, the detector matrix 22, reset and buffer field effect transistor circuits 86, preamplifier 88 and clamp-sample and hold circuits 90. For ramped operation, a ramp waveform generator 92 (Fig. 7b) is included between the horizontal scan generator 84 and the RAI 22; otherwise the two structures are the same.

In the non-ramped structure the horizontal scan generator 84, which is, for example, a ring counter, supplies the waveforms, hereinafter described, to the detector address lines 30, 32, and 34. The read lines 36, 38 and 40 and their corresponding output collectors 48, 50 and 52 (Fig. 2a) are each connected to reset and buffer FET circuits 86 (Fig. 7a). Reset and buffer FET circuits are also connected to the preamplifiers 88. The preamplifiers 88 have their outputs connected to clamp-sample-and-hold circuits 90.

In the ramped mode (Fig. 7b), each output of the horizontal scan converter 84 activates a ramp waveform generator 92. The waveform generator is, for example, an RC charging circuit followed by an operational amplifier, in this form, the linear portion of the RC rise time is used. In another embodiment, the ramp generator can approximate a linear ramp by providing a series of closely spaced step increases in voltage.

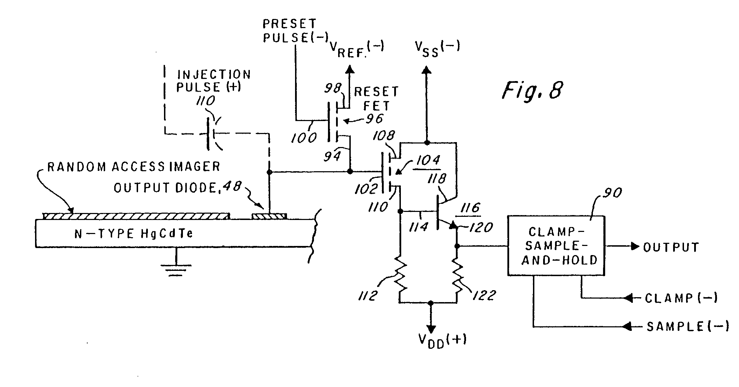

The RAI output circuit (Fig. 8) used to sense the charge on each output collector is identical for each column of elements. Thus, only one circuit need be described; the circuit includes either the p—n junction output diode 48 whose anode is connected to source 94 of reset MOSFET 96 or the MIS structure whose electrode is connected to source 94 of reset MOSFET 96. MOSFET 96 has its drain 98 connected to a reference voltage and its gate 100 connected to a preset pulse. When a preset pulse is received, the negative reference voltage is applied to the anode of the p—n junction output diode and gate 102 of buffer MOSFET 104. Buffer MOSFET 104 has its source 108 connected to a negative $V_{ss}$ voltage and its drain 110 connected to load resistor 112 connected to a positive $V_{DD}$ source and base 114 of bipolar transistor 116. Transistor 116 has its emitter 118 connected to the negative $V_{ss}$ voltage and its collector output connected to load resistor 122 connected to the $V_{DD}$ source, and to the input of the clamp-sample and hold circuit 90.

In the embodiment where the output collector is an MIS structure, an injection pulse capacitor 110, shown in dotted line in Figure 8, is provided.

The reset and buffer MOSFETS can be in a separate silicon chip adjoining the detector RAI chip or alternatively, the reset and buffer MOSFETS can be built directly on the same chip as the RAI; in this monolithic version using the output diode 48, this diode can be the source of the reset MOSFET.

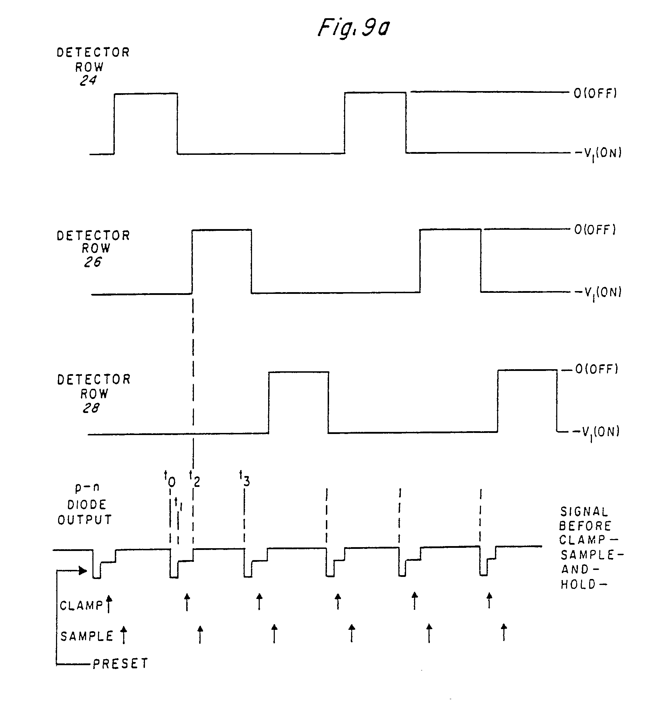

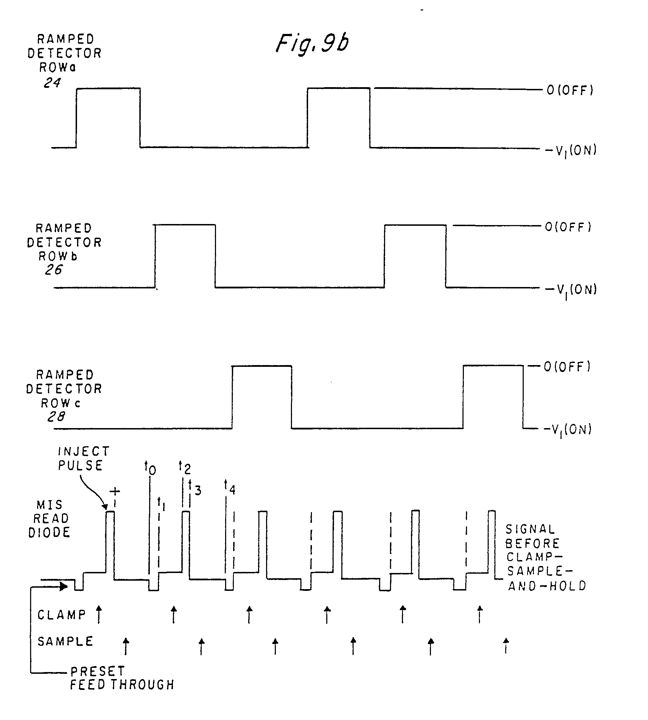

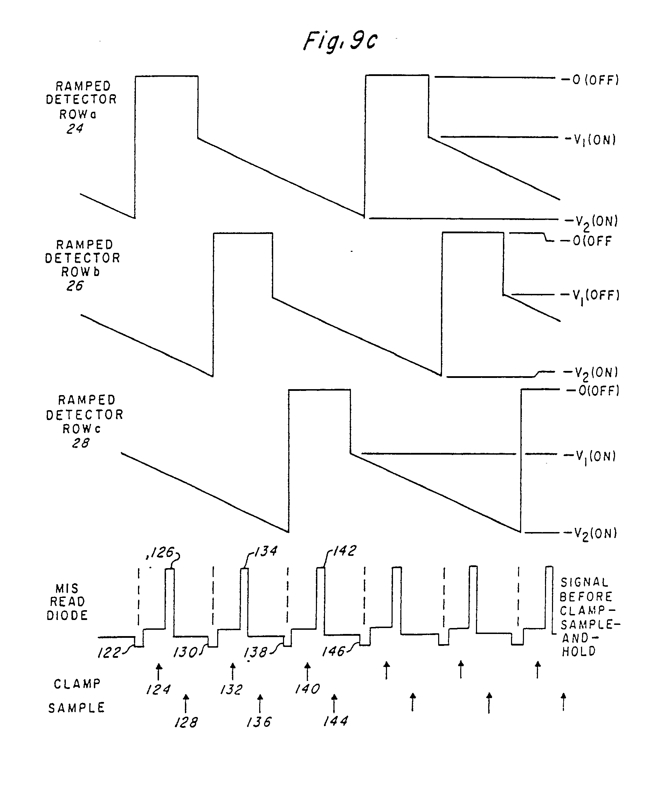

Figures 9a, 9b, and 9c show the voltages applied to the detector rows 24, 26, and 28 for the case using n-type material with zero volts being "off" and $-V_1$ or $-V_2$ "on" and thereby creating a potential well under the row electrodes 24, 26, and 28. As row wells 24 turn off, row wells 26 turn on, and so forth. The turn-off of row 24 and the turn-on of row 26 can be simultaneous or 24 may turn-off slightly before 26 turns on, and so forth. The waveforms at the bottom of Figures 9a, 9b, and 9c show the voltage output at 48, 50, and 52. The arrows show the timing of the clamp and sample pulses.

Referring now to Figure 9a for a description of the operation of the device when p—n junction type (diode) collectors 48, 50, and 52 are used.

With row of detector elements 24 off and having already dumped their charges into the collector diodes 48, 50 and 52 (Fig. 2a) and rows of detector elements 26 and 28 on and charging, a negative preset voltage pulse is applied during time $t_0$—$t_1$ to the charge collecting diodes 48, 50, and 52. The reset pulse sets the diode to a fixed known voltage prior to dumping charge onto the diode from row detectors. Next, during the time $t_1$—$t_2$ the reset pulse is turned off and the voltage on the diodes 48, 50, and 52 are measured and amplified by buffer 104 (Fig. 8) and clamped by CS&H circuit 90. At the time $t_2$ the row of detector elements 26 is turned off and the charges of their potential wells dumped during time $t_2$—$t_3$ through read lines 42, 44, and 46 (Fig. 2a) into the collector diodes 48, 50 and 52. The collector diodes 48, 50 and 52 voltage outputs are buffered and sampled by CS&H circuit 90 (Fig. 8). The clamped voltage is subtracted from the sampled voltage and the difference represents the intensity of the infrared photon flux impinging on the second row of detector elements 26. At $t_3$ (which is also $t_0$) the second cycle begins with the second row of detector elements being turned on by the second reset pulse for charging. At the end of the second cycle ($t_3$), the charges of the third row of detector elements 28 have been determined, and the row of detector elements 28 turned on again. Then the third cycle begins with the row of detector elements 24 being turned off, and at the end of the third cycle the charges of the first row of detector elements 24 have been determined and the first row of detector elements 24 turned on again. The cycle continues throughbut the RAI operation. Although the selection of rows has been shown in a sequential operation, the rows may be selected randomly.

For operation of the MIS embodiment of the RAI, the timing and waveforms are shown in Fig. 9b. With the row of detector elements 24 off and having dumped and the rows of detector elements 26 and 28 on and charging at $t_0$, a reset pulse is applied to the MIS output elements 48, 50, and 53 to set the potential wells underneath these MIS electrodes to a fixed constant surface potential. At $t_1$, the reset pulse is turned off.

Between the $t_0$ and $t_1$, the second row of detector elements 26 are turned off and their charges are dumped into the read lines 42, 44, and 46. During the time $t_1$—$t_2$, the voltages of the MIS output electrodes 48, 50 and 52 are measured and clamped by the buffer and CS&H circuit (Fig. 8). At the time $t_2$—$t_3$ (Fig. 9b) an injection pulse is applied to the barrier gate switch 78 which is turned off slightly prior to $t_2$ and turned on slightly after $t_3$. Because the barrier gate switch is off during the time of the application of the injection pulse, the charges underneath the MIS output electrodes are injected into the substrate rather than back into the read lines 42 and 44 of Figure 5. Next, during the time $t_3$—$t_4$ the charge collectors 48, 50, and 52 are sampled by the CS&H circuit 90 (Fig. 8) and the difference in the clamped and sampled voltages determined. This difference voltage represents the intensity of the infrared photon flux impinging on the rows of detector elements 26. At $t_4$ or $t_0$ of a cycle, a second reset pulse is applied to determine the charges of the third row of detector elements 28. Finally, the cycle is repeated for a third cycle to determine the charges of the first row of detector elements 24. The cycle is continued throughout RAI operation. The clamp and sample pulses in Figure 9b are shown centered around the injection pulse and thereby detecting the charge injected into the substrate; in an alternate scheme, the preset pulse can be applied and turned off prior to the turn off of detector row 26 and the clamp and sample pulses centered around the turn off of detector row 26 thereby detecting the charge transferred underneath the output MIS electrodes 48, 50, and 52.

When the rows of detectors 24, 26, and 28 are ramped, multiple amplitude voltages are applied as shown in Figure 9c. The potential wells are formed by biasing the metal gases 72 (Fig. 3b) of the rows of MIS elements 24, 26 and 28 (Fig. 2a) to a voltage to drive away the majority carriers from the surface of the semiconductor to uncover net impurity charge density $Q_D$ in a depletion layer and to permit the collection of mobile carrier charge density $Q_{INV}$ in the potential well with surface density $\psi_S$. The relationship between $\psi_S$ V, Q and the insulator capacitance per unit area is:

$$-(V-\psi_S)=Q/C_{ins}=Q_{INV}/C_{INS}+Q_D/C_{INS} \qquad (1)$$

The thickness of the layer containing $Q_{INV}$ (less than $16^{-6}$ cm) when compared to the thickness of the layer containing $Q_D$ (greater than $10^{-4}$ cm) can be omitted and, $Q_D$ is written in terms of $\psi_S$ using

$$V_0=(gN\xi_0\varepsilon)/C^2_{INS}$$

where g is the electronic charge, N the net impurity concentration in the semiconductor, $\xi_0$ is the dielectric permittivity of free space, and $\varepsilon$ is the dielectric constant of the semiconductor. The result for a p-type semiconductor with positive V and $\psi_S$ and with negative $Q_{INV}$ is:

$$-V+\psi_S\cong Q_{INV}/C_{INS}-\sqrt{2V_0\psi_S} \qquad (2)$$

$$\sqrt{\psi_S}=-\sqrt{V_0/2}+\sqrt{V_0/2+V+Q_{INV}/C_{INS}} \qquad (3)$$

The electric field $E_S$ at the surface of the semiconductor is:

$$E_S=\sqrt{2\psi_S gN/(\xi_0\varepsilon)}$$

The charge stored in the well is related to $\psi_S$ or $E_S$ through equation (2). Thus,

$$Q_{INV}=-C_{INS}(V-\psi_S-\sqrt{2V_0\psi_S}) \qquad (4)$$

In the case of a full well:

$$Q_{FW}=C_{INS}(V-V_T) \qquad (5)$$

where:

$V_T$=the threshold for inversion.

In the usual mode of operation of a CTD, the gate voltages are pulsed between a maximum and a minimum gate voltage. In this mode, the MIS gate voltage V which gives the maximum empty well depth $\psi_S$ (or electric field $E_S$) in turn determines the maximum amount of charge $Q_{FW}$ which the well can contain. The maximum $E_S$ may be set by electric breakdown in the semiconductor. If the maximum $E_S$ in the semiconductor is very large, the maximum gate voltage may be set by electric breakdown in the insulator. In the case of silicon MIS devices, the maximum $E_S$ is in the range of $10^6$ V/cm and the maximum $\psi_S$, V, and $Q_{FW}$ are set by electric breakdown in the insulator. The maximum permissible electric field in the semiconductor is much smaller in narrow band gap semiconductors such as InSb and InAs and the alloy semiconductors HgCdTe, InAsSb, GaInSb, and PbSnTe. In the case of HgCdTe, the maximum $E_S$ is $10^4$ V/cm for an alloy composition to give an infrared response with long wavelength response threshold at 10 μm and is $3\times10^4$ V/cm for an alloy composition to give a response threshold at 5 μm. This wavelength threshold may be set by tunnel current $I_T$ breakdown which is related to $E_S$ and the bandgap $E_G$ of the semiconductor

$$I_T=(AE_S^4/E_G^2)\exp(-BE^2_G/E_S) \qquad (5)$$

where A and B are constants and $E_G$ is the semiconductor forbidden bandgap energy which is related to the wavelength cutoff $\lambda_c$ by Plank's constant h and the speed of light $c(E_G=hc/\lambda_c)$.

In detecting either visible or infrared images, photons pass through the semitransparent substrate or semitransparent electrodes and are absorbed in the semiconductor where the absorption process creates minority carriers which can be collected in the CTD potential well. The sensitivity of the CTD as an infrared sensor is proportional to the maximum time (maximum integration time) the well can collect signal generated charge. The signal-to-noise ratio of the infrared CTD is proportional to the square root of the maximum integration time. Unfortunately, in addition to the infrared signal generated charge, there is a much larger charge generated due to the infrared coming from viewing room temperature background. This infrared background generated charge limits the maximum integration time for signal generated charge. The relatively low maximum $E_s$ in long wavelength response semiconductors such a HgCdTe severely limits the maximum charge capacity of the well and thereby the maximum integration time, maximum signal, and maximum signal-to-noise ratio of the infrared sensitive CTD.

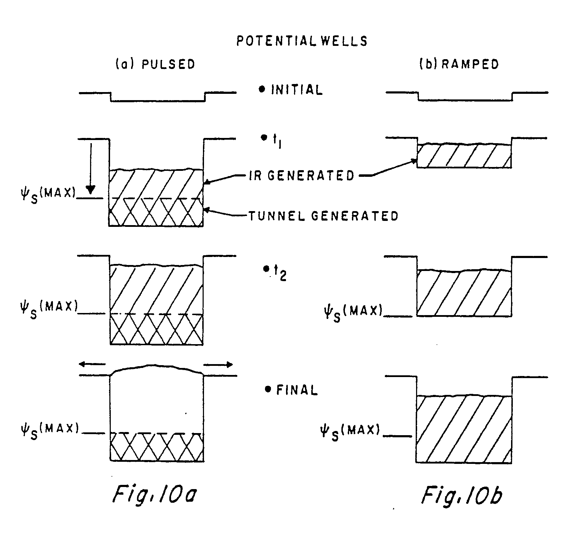

Figure 10a shows the standard mode of infrared detection in an MIS well of a CTD array in which the gate voltage is pulsed from an initial low value to a large value to create a potential well in the semiconductor. The initial $\psi_s$ created is given by the depth of the potential wells shown in Figure 10a. Figure 1a shows the case with the initial $\psi_s$ larger than the tunnel threshold $\psi_s$ (max) value: in this case, charge very rapidly tunnels to the well to partially fill the well to the dashed line at $\psi_s$ (max). After this initial tunnel current, the infrared generated minority carriers slowly begin to fill the well as shown for times $T_1$ and $T_2$. Finally, the potential well overfills as shown at the bottom of Figure 10a because the tunnel current has reduced the charge capacity available for the storage of infrared generated minority carriers. Signal charge cannot be collected for a time longer than that for which the tunnel and background generated carriers completely fill the well.

When the MIS gate voltage is ramped in the presence of an infrared background which creates a minority carrier current density $J_0$ amps/cm², $Q_{INV}$ increases simultaneously with the increase in V. Equation 3 shows that if the rate of increase of $Q_{INV}/C_{INS}$ just balances the rate dV/dt of increase of V, then the surface potential $\psi_s$ will not change. Since $J_0=-dQ_{INV}/dt$, the requirement for a constant $\psi_s$ during the ramp of a partially filled well is

$$dV/dt=J_0/C_{INS} \qquad (6)$$

If dV/dt is slightly larger than $J_0/C_{INS}$, the surface potential will slowly increase. If (dV/dt$-J_0/C_{INS}$) is small enough, it will take an extremely long time for $\psi_s$ to reach $\psi_s$ (max). Thus, the large charge generation rate due to infrared background which was a problem for the pulsed mode of Figure 10a can be used to suppress the creation of tunnel generated charge when a gate voltage ramp is used.

Figure 10b shows the growth of surface potential and stored charge for the ramped MIS over the same times as those shown in Figure 10a. The same MIS structure was used for determining the growth of surface potential shown in Figures 10a and 10b. In Figure 10b, the well does not overfill because no tunnel generated charged has appeared in the well. Large increases in maximum integration time can be obtained for closely balanced ramps. A maximum ramped integration time 17-times longer than that obtained for a pulsed MIS has been observed for a HgCdTe MIS with a 9.4 m long-wavelength cutoff in a 20° field-of-view for ambient radiation.

The desired ramp effect on $\psi_s$ may be improved through device design by utilizing an MIS. electrode which has a small opaque region, and which has an inversion threshold slightly smaller than that for the larger area transparent region. In this design, the first effect of the ramp is to create a small empty well under the opaque electrode which is insensitive to infrared. When the gate voltage becomes larger than inversion threshold for the large area transparent gate region of the MIS, the infrared sensitive potential well starts out partially empty due to the diversion of photogenerated carriers to the opaque portion of the well. The ramp rate is chosen so that the surface potential does not increase after the gate voltage is large enough to turn on both portions of the well. The difference in flatband voltages between the transparent and opaque portions of the MIS must be smaller than that difference which would cause the potential well underneath the opaque electrode portion from reaching the tunnel threshold before the potential well underneath the transparent electrode portion turns on.

Thus, as shown in Figure 9c, a preset pulse 122 is applied to set the output collector 48, 50 and 52 to a reference voltage. During the preset pulse 122, the first row of detector elements 24 are turned off to dump their charges into the read line. While off, the clamp sample and hold (CS&H) circuit 90 during clamping period 124, clamps the buffered output of the output collector to hold the voltage of the output collectors 48, 50, and 52. Next, while the first row of detector elements are off an injection pulse 126 is applied to the output MIS collectors 48, 50, and 52 to collapse these wells while simultaneously the barrier gate switch 78 is closed so that the charges underneath the MIS collectors are injected into the substrate. Next, the buffered output of output collectors 48, 50 and 52 during the period 128 are sampled by the CS&H circuit 90 and the voltage difference determined. The voltage difference represents the value of the infrared generated charge accumulated in the first row of ramped detector elements 24. If p—n junction diodes 48, 50, and 52 had been used, the output scheme shown at the bottom of Figure 9a could have been used.

Near the end of sampling, the first row of detector elements 24 are turned on $(-V_1)$ and ramping to votage $(-V_2)$ begun. During a second preset pulse 130 the output collector is set to the reference voltage, and the second row of detector elements 26 are turned off to dump the charge of the second row of the detector elements into the read line. Next during the clamping period 132, the buffered voltages of the output collectors 48, 50 and 52 are clamped by CS&H circuits 90.

Then, while the second row of detector elements 26 are off, barrier gate 78 is turned off and a second injection pulse 134 applied to the output collectors 48, 50, and 52 and the buffered output, during a sampling period 136, sampled by CS&H circuit 90. The voltage difference indicates the infrared generated charge in the second row detector elements 26. During this time, the ramping of the first row of detector elements 24 continues. Near the end of the second row sampling, the second row of detector elements 26 are turned on by a voltage (−V) and the ramping to voltage −$V_2$ begun. The cycle is completed by a third preset pulse 138 which again sets the collector output to a reference voltage. During preset the third row of detector elements 28 are turned off to dump their charge into the read line. The output collector is clamped during clamping period 140 to receive the outputs of the third row of detectors 28.

Next, while the third row of detector elements 28 are still off an injection pulse 142 is applied to the collector electrodes 48, 50, and 52 and simultaneously the barrier gate 78 is turned off to dump charges in output charge collectors 48, 50 and 52 into the substrate. The buffered outputs of the charge collectors 48, 50, and 52 are sampled during sampling period 144 by the CS&H circuit 90 and the voltage difference represents the value of the infrared energy generated charge on the third row of detector elements 28. Near the end of sampling 144 the ramping of the first row of detectors 24 is completed, and the ramping of the second row of detectors 26 continues. Then a preset pulse 146 is applied to the output collectors 48, 50, and 52 to set them at reference voltage, and the first row of detectors 24 are turned off to dump the charge therein into the read line to start a new cycle of operation. The potential wells generated during the three stages (a, b and c) are shown in Figure 4.

The preferred embodiment utilizes a p—n junction read line 72 of Figure 4 to give rapid flow of the carriers from the detector wells 24, 26, and 28 to the output devices 48, 50, and 52. One purpose of the barrier well 80 of Figure 6 is to provide a background charge in the MIS read line to shorten the response time of this read line.

Although several embodiments of this invention have been described herein, it will be apparent to a person skilled in the art that various modifications to the details of construction shown and described may be made without departing from the scope of this invention. For instance, a threshold shifting ion implant in the region of the dc transfer gates 36, 38, and 40 can be used to form the desired potential in these regions without the use of the dc transfer gates thus eliminating one set of electrodes. Also if an ion implant and/or thick insulator is used in the field stop region 60 and this implant and/or insulator are/is sufficient to keep the surface under 60 accumulated, then the field plate/channel stop MIS electrode can be eliminated.

**Claims**

1. An infrared imaging system comprising, a random access imager including a scan generator (84), a semiconductor substrate (54) of one conductivity type having a plurality of detector elements (24, 26, 28) for receiving infrared energy and storing charges representative of the impinging energy, said detector elements being arranged in rows and columns and operatively connected to the scan generator (84), output collector means (48, 50, 52), each of which comprises a read line (42, 44, 46) which is continuous along its length and connected to each of the detector elements (24, 26, 28) in a column for selectively collecting the charges of the detector elements and circuit means (90) connected to said output collector means for determining the quantity of charge representative of the infrared energy impinging on the detector elements; and a signal processing means (18) for processing the electrical energy representative of the infrared energy emanating from a scene into video signals, characterized in that the imaging system comprises a lens system (12) for focussing infrared energy emanating from a scene, the random access imager detector elements (24, 26, 28) and output collector means (48, 50, 52) further comprise a first level of electrodes (60, 72) and a first insulating layer (58) sandwiched between the substrate (54) and the first level electrodes, said first level electrodes defining the detector areas and output collector means, a second layer (62) of insulating material covering the first layer of insulating material and the first level electrodes (60, 72), second level electrodes (64) formed on the second insulator layer (62) for the detector elements, a third insulator layer (66) formed over the second insulator layer (62) and the second level electrodes, and third level electrodes (36, 38, 40) selectively interconnecting the output collector to columns of detector elements.

2. An infrared imaging system comprising, a random access imager including a scan generator (84), a semiconductor substrate (54) having a plurality of detector elements (24, 26, 28) for receiving infrared energy and storing charges representative of the impinging infrared energy, said detector elements being arranged in rows and columns and operatively connected to the scan generator (84), output collector means (48, 50, 52), each of which comprises a read line (42, 44, 46) which is continuous along its length and connected to each of the detector elements (24, 26, 28) of a column for selectively collecting the charges of the detector elements; circuit means (90) connected to said output collector means for determining the quantity of charge representative of the infrared energy impinging on the detector element; and a signal processing means (18) for processing the electrical energy representative of the infrared energy emanating from a scene into video signals; characterized in that the imaging system comprises a lens system for focussing infrared energy emanating from a scene, the output collector means comprises p—n junction regions in the semiconductor substrate (54) and the imager includes a first layer (58) of insulating material covering the substrate, first level electrodes (60) formed on the first insulating area forming a field plate channel stop, a second insulating layer (62) covering the first level electrodes and the first insulating layer (58), electrodes (64) transparent to infrared energy formed on the second insulating layer (62), said electrodes defining the MIS detector element areas, leads (30) formed on the second insulating layer selectively connecting the transparent electrodes, a third insulation layer (66) formed over the transparent electrode leads (64), and second insulator layer (62), and transfer gate electrodes (46, 38, 40) formed on the third insulation layer over the p—n regions for selectively interconnecting the detector elements to the output collector means.

3. An infrared imaging system according to claim 1 or 2 further characterized by a ramp waveform generator having outputs connected to the scan generator and outputs connected to rows of the detector elements for providing to the detector elements voltage amplitudes which increase with time.

4. A method of imaging infrared energy emanating from a scene using an infrared imaging system according to claim 3 comprising focusing infrared energy emanating from a scene onto the matrix of detector elements (24, 26, 28) in the random access imager; applying voltage amplitudes which increase continuously with time to the matrix of detector elements for establishing potential wells of the detector elements of increasing capacity corresponding to the increase in charge generated by the impinging infrared energy; dumping the charge of each detector element by rows into the sigle element read lines (42, 44, 46) by decreasing the voltage amplitude to the matrix of detector elements; collecting the charge from each read line in the charge collector (48, 50, 52); and applying the charge in each charge collector to the charge determining circuit (90) for producing electrical signals representative of the infrared energy emanating from the scene.

5. A method of imaging infrared energy emanating from a scene using the infrared imaging system of claim 1 or 2 comprising focusing infrared energy emanating from a scene onto a matrix of detector elements (24, 26, 28) in a random access imager; applying voltage amplitudes of substantially constant value to the detector elements for establishing potential wells; dumping the charge of each detector element by rows into single element read lines by decreasing the voltage amplitude to the matrix of detector elements; collecting the charge from each read line in a charge collector (48, 50, 52);

and applying the charge in each charge collector to a charge determining circuit (90) for producing electrical signals representative of the infrared energy emanating from the scene.

**Revendications**

1. Système de formation d'images en infrarouge, comportant un dispositif de formation d'images à accès direct comprenant un générateur de balayage (84), un substrat semiconducteur (54) d'un type de conductivité comprenant plusieurs éléments détecteurs (24, 26, 28) pour recevoir de l'énergie infrarouge et pour emmagasiner des charges représentant l'énergie reçue, lesdits éléments détecteurs étant disposés en rangées et en colonnes et étant connectées au générateur de balayage (84), des collecteurs de sortie (48, 50, 52) comprenant chacun une ligne de lecture (42, 44, 46) qui est continue sur sa longueur et qui est connectée à chacun des éléments détecteurs (24, 26, 28) dans une colonne pour recueillir sélectivement les charges des éléments détecteurs, et un circuit (90) connecté auxdits collecteurs de sortie pour déterminer la quantité de charge représentant l'énergie infrarouge reçue par les éléments détecteurs; et un dispositif de traitement de signaux (18) destiné à traiter l'énergie électrique représentant l'énergie infrarouge provenant d'une scène, endes signaux vidéo, caractérisé en ce que le système de formation d'images comporte un système de lentilles (12) pour focaliser de l'énergie infrarouge provenant d'une scène, les éléments détecteurs (24, 26, 28) du dispositif de formation d'images à accès direct et les collecteurs de sortie (48, 50, 52) comportant en outre un premier niveau d'électrodes (60, 72) et une première couche isolante (58) intercalée entre le substrat (54) et les électrodes du premier niveau, les électrodes du premier niveau définissant les régions de détecteurs et les collecteurs de sortie, une seconde couche (62) de matière isolante recouvrant la première couche de matière isolante et les électrodes de premier niveau (60, 72), des électrodes de second niveau (64) formées sur la seconde couche isolante (62) pour les éléments détecteurs, une troisième couche isolante (66) formée au-dessus de la seconde couche isolante (62), et des électrodes du second niveau, et des électrodes d'un troisième niveau (36, 38, 40) interconnectant sélectivement les collecteurs de sortie à des colonnes d'éléments détecteurs.

2. Système de formation d'images en infrarouge comportant un dispositif de formation d'images à accès direct comprenant un générateur de balayage (84), un substrat semiconducteur (54) comprenant plusieurs éléments détecteurs (24, 26, 28) pour recevoir de l'énergie infrarouge et pour emmagasiner des charges représentant l'énergie infrarouge reçue, lesdits éléments détecteurs étant disposés en rangées et en colonnes et étant connectés au générateur de balayage (84), des collecteurs de sortie (48, 50, 52) comportant chacun une ligne de lecture (42, 44, 46) qui est continue sur sa longueur et qui est connectée à chacun des éléments détecteurs (24, 26, 28) d'une colonne pour recueillir sélectivement les charges des éléments détecteurs; un circuit (90) connecté auxdits collecteurs de sortie pour déterminer la quantité de charge représentant l'énergie infrarouge reçue par les éléments détecteurs; et un dispositif de traitement de signaux (18) destiné à traiter l'énergie électrique représentant l'énergie infrarouge provenant d'une scène, en des signaux vidéo, caractérisé en ce que le système de formation d'images comporte un système de lentilles pour focaliser de l'énergie infrarouge provenant d'une scène, les collecteurs de sortie consistant en des régions de jonction PN dans le substrat semiconducteur (54) et le dispositif de formation d'images comportant une première couche (58) de matière isolante recouvrant le substrat, des électrodes d'un premier niveau (60) formées sur la première région isolante, et constituant une plaque de champ arrêt de canal, une seconde couche isolante (62) recouvrant les électrodes du premier niveau et la première couche isolante (58), des électrodes (64) transparentes à l'énergie infrarouge formées sur la seconde couche isolante (62), lesdites électrodes définissant les régions d'éléments détecteurs MIS, des conducteurs (30) formés sur la seconde couche isolante connectant sélectivement les électrodes transparentes, une troisième couche isolante (66) formée au-dessus des conducteurs d'électrodes transparentes (64) et la seconde couche isolante (62) et des électrodes de grilles de transfert (46, 38, 40) formées sur la troisième couche isolante au-dessus des régions PN pour interconnecter sélectivement les éléments détecteurs aux collecteurs de sortie.

3. Système de formation d'images en infrarouge selon la revendication 1 ou 2, caractérisé en ce qu'il comporte un générateur de formes d'ondes en rampe comprenant des sorties connectées au générateur de balayage et des sorties connectées aux rangées d'éléments détecteurs pour appliquer aux éléments détecteurs des amplitudes de tension qui croissent avec le temps.

4. Procédé de formation d'images d'énergie infrarouge provenant d'une scène, en utilisant un système de formation d'images en infrarouge selon la revendication 3, consistant à focaliser de l'énergie infrarouge provenant d'une scène sur une matrice d'éléments détecteurs (24, 26, 28) dans le dispositif de formation d'images à accès direct, à appliquer des amplitudes de tension qui croissent continuellement avec le temps à la matrice d'éléments détecteurs pour établir des puits de potentiel des éléments de détecteur de capacité croissante correspondant à l'augmentation de charge produite par l'énergie infrarouge reçue, à écouler la charge de chaque élément détecteur par des rangées dans les lignes de lecture d'un seul élément (42, 44, 46) en diminuant l'amplitude de la tension à la matrice des éléments détecteurs, à recueillir la charge de chaque ligne de lecture dans le collecteur de charge (48, 50, 52); et à appliquer la charge de chaque collecteur de charge au circuit de détermination de charge (90) pour produire des signaux électriques représentant l'énergie infrarouge provenant de la scène.

5. Procédé de formation d'images d'énergie infrarouge provenant d'une scène, utilisant le système de formation d'images en infrarouge de la revendication 1 ou 2, consistant à focaliser de l'énergie infrarouge provenant d'une scène sur une matrice d'éléments détecteurs (24, 26, 28) dans un dispositif de formation d'images à accès direct; à appliquer des amplitudes de tension d'une valeur pratiquement constante aux éléments détecteurs pour établir des puits de potentiel; à écouler la charge de chaque élément détecteur par des rangées dans des lignes de lecture d'un seil élément en diminuant l'amplitude de tension à la matrice d'éléments détecteurs; à recueillir la charge de chaque ligne de lecture dans un collecteur de charge (48, 50, 52); et à appliquer la charge de chaque collecteur de charge à un circuit de détermination de charge (90) pour produire des signaux électriques représentant l'énergie infrarouge provenant de la scène.

**Patentansprüche**

1. Infrarot-Abbildungssystem mit einer Abbildungsvorrichtung mit wahlfreiem Zugriff mit einem Abtastgenerator (84), einem Halbleitersubstrat (54) eines Keitungstyps, mit mehreren Detektorelementen (24, 26, 28) für den Empfang von Infrarotenergie und das Speichern von die auftreffende Energie repräsentierenden Ladungen, wobei die Detektorelemente in Reihen und Spalten angeordnet und mit dem Abtastgenerator (84) wirkungsmäßig verbunden sind, Ausgangskollektormitteln (48, 50, 52), die jeweils eine Leseleitung (42, 44, 46) enthalten, die in ihrer Längenausdehnung durchgehend ausgebildet ist und an jedes der Detektorelemente (24, 26, 28) in einer Spalte angeschlossen ist, damit die Ladungen der Detektorelemente in ausgewählter Weise gesammelt werden, an die Ausgangskollektormittel angeschlossenen Schaltungsmitteln (90) zum Feststellen der Ladungsmenge, die die auf die Detektorelemente auftreffende Infrarotenergie repräsentiert, und einem Signalverarbeitungsmittel (18) zum Verarbeiten der die von einer Szene ausgehenden Infrarotenergie entsprechenden elektrischen Energie in Videosignale, dadurch gekennzeichnet, daß das Abbildungssystem ein Linsensystem (12) zum Fokussieren von Infrarotenergie enthält, die von einer Szene ausgeht, daß die Detektorelemente (24, 26, 28) der Abbildungsvorrichtung in wahlfreiem Zugriff und die Ausgangskollektormittel (48, 50, 52) ferner ein erstes Niveau von Elektroden (60, 72) und eine erste Isolierschicht (58) zwischen dem Substrat (54) und den Elektroden des ersten Niveaus enthalten, daß die Elektroden des ersten Niveaus die Detektorflächen und die Ausgangskollektormittel bilden, daß die erste Schicht aus Isoliermaterial und die Elektroden (60, 72) des ersten Niveaus mit einer zweiten Schicht (62) aus Isoliermaterial bedeckt sind, daß auf der zweiten Isolierschicht (62) Elektroden (64) eines zweiten Niveaus für die Detektorelemente gebildet sind, daß über der zweiten Isolierschicht (62) und den Elektroden des zweiten Niveaus eine dritte Isolierschicht (66) gebildet ist, und daß Elektroden (36, 38, 40) eines dritten Niveaus die Ausgangskollektormittel wahlweise mit Spalten der Detektorelemente verbinden.

2. Infrarot-Abbildungssystem mit einer Abbildungsvorrichtung mit wahlfreiem Zugriff mit einem Abtastgenerator (84), einen Halbleitersubstrat (54) eines Leitungstyps, mit mehreren Detektorelementen (24, 26, 28) für den Empfang von Infrarotenergie und das Speichern von die auftreffende Energie repräsentierenden Ladungen, wobei die Detektorelemente in Reihen und Spalten angeordnet und mit dem Abtastgenerator (84) wirkungsmäßig verbunden sind, Ausgangskollektormitteln (48, 50, 52), die jeweils eine Leseleitung (42, 44, 46) enthalten, die in ihrer Längsausdehnung durchgehend ausgebildet ist und an jedes der Detektorelemente (24, 26, 28) in einer Spalte angeschlossen ist, damit die Ladungen der Detektorelemente in ausgewählter Weise gesammelt werden, an die Ausgangskollektormittel angeschlossenen Schaltungsmitteln (90) zum Feststellen der Ladungsmenge, die die auf die Detektorelemente auftreffende Infrarotenergie repräsentiert, und einem Signalverarbeitungsmittel (18) zum Verarbeiten der die von einer Szene ausgehende Infrarotenergie entsprechenden elektrischen Energie in Videosignale, dadurch gekennzeichnet, daß das Abbildungssystem ein Linsensystem (12) zum Fokussieren von Infrarotenergie enthält, die von einer Szene ausgeht, daß die Ausgangskollektormittel pn-Übergangszonen in dem Halbleitersubstrat (54) enthalten, daß die Abbildungsvorrichtung eine erste Schicht (58) aus Isoliermaterial enthält, die das Substrat bedeckt, daß auf dem ersten isolierenden Bereich Elektroden (60) eines ersten Niveaus gebildet sind, die eine Feldplatten-Kanalbegrenzung bilden, daß die Elektroden des ersten Niveaus und die erste Isolierschicht (58) mit einer zweiten Isolierschicht (62) bedeckt sind, daß auf der zweiten Isolierschicht (62) für Infrarotenergie durchlässige Elektroden (64) gebildet sind, die die MIS-Detektorelementflächen bilden, daß auf der zweiten Isolierschicht gebildete Leiter (30) die durchlässigen Elektroden in ausgewählter Weise verbinden, daß über den Leitern der durchlässigen Elektroden (64) und der zweiten Isolierschicht (62) eine dritte Isolierschicht (66) gebildet ist, und daß auf der dritten Isolierschicht über den pn-Zonen Übertragungstorelektroden (46, 38, 40) gebildet sind, die die Detektorelemente in ausgewählter Weise mit den Ausgangskollektormitteln verbinden.

3. Infrarot-Abbildungssystem nach Anspruch 1 oder 2, gekennzeichnet, durch einen Sägezahngenerator mit an den Abtastgenerator angeschlossenen Ausgängen und mit an die Reihen der Detektorelemente angeschlossenen Ausgängen zum Anlegen von zeitlich ansteigenden Spannungsamplituden and die Detektorelemente.

4. Verfahren zum Abbilden der von einer Szene ausgehenden Infrarotenergie unter Verwendung eines Infrarot-Abbildungssystems nach Anspruch 3, bei welchem die von einer Szene ausgehende Infrarotenergie auf die Matrix aus Detektorelementen (24, 26, 28) in der Abbildungsvorrichtung mit wahlfreiem Zugriff fokussiert wird, an die Matrix aus Detektorelementen zeitlich kontinuierlich ansteigende Spannungsamplituden angelegt werden, damit Potentialsenken der Detektorelemente mit vergrößerter Kapazität entsprechend dem durch die auftreffende Infrarotenergie erzeugten Ladungsanstieg gebildet werden, die Ladung jedes Detektorelements reihenweise in die für ein Element vorgesehenen Leseleitungen (42, 44, 46) abgeleitet wird, indem die Amplitude der an die Matrix aus Detektorelementen angelegten Spannung abgesenkt wird, die Ladung aus jeder Leseleitung im Ladungskollektor (48, 50, 52) gesammelt wird und die Ladung in jedem Ladungskollektor an eine Ladungsbestimmungsschaltung (90) angelegt wird, damit elektrische Signale erzeugt werden, die die von der Szene ausgehende Infrarotenergie repräsentieren.

5. Verfahren zum Abbilden der von einer Szene ausgehenden Infrarotenergie unter Verwendung eines Infrarot-Abbildungssystems nach Anspruch 1 oder 2, bei welchem die von einer Szene ausgehenden Infrarotenergie auf eine Matrix aus Detektorelementen (24, 26, 28) in einer Abbildungsvorrichtung mit wahlfreiem Zugriff fokussiert wird, Spannungsamplituden mit im wesentlichen konstantem Wert an die Detektorelemente zum Erzeugen von Potentialsenken angelegt werden, die Ladung jedes Detektorelements reihenweise in für ein Element vorgesehene Leseleitungen abgeleitet wird, indem die Amplitude der an die Matrix aus Detektorelementen angelegten Spannung abgesenkt wird, die Ladung aus jeder Leseleitung in einem Ladungskollektor (48, 50, 52) gesammelt wird, und die Ladung in jedem Ladungskollektor an eine Ladungsbestimmungsschaltung (90) angelegt wird, damit ein elektrisches Signal erzeugt wird, das die von der Szene augehende Infrarotenergie repräsentiert.

# 0 065 599

*Fig. 1*

*Fig. 3a*

*Fig. 3b*

Fig. 2a

## Fig. 2b

DETECTOR ADDRESS(a)

30

64  64  64

62

DETECTOR ADDRESS(b)

32

64  64  64

22

DETECTOR ADDRESS(c)

34

64  64  64

READ LINE

62

OUTPUT DIODE

62

## Fig. 2c

READ LINE

OUTPUT DIODE

60, FIELD PLATE/CHANNEL STOP

22

4

# Fig. 4

38    Al
66    ZnS
62    ZnS
76   72   74   76   60
60    Al
58    ZnS
56    OXIDE
54    HgCdTe
POTENTIAL

# Fig. 6

36    Al
66    ZnS
80
62   72   76   74   ZnS
60    Al
58    ZnS
56    OXIDE
OFF
54    HgCdTe
POTENTIAL

GUARD    READ LINE    OUTPUT DIODE    GUARD RING
PULSED

Fig. 5

Fig. 7a

Fig. 7b

7

Fig. 8

PRESET
PULSE(−) V$_{REF.}$(−)    V$_{SS}$(−)

INJECTION
PULSE (+)
110

RESET
98 FET
100    96
108
94

RANDOM ACCESS IMAGER
OUTPUT DIODE, 48

N−TYPE HgCdTe

104
102    118
110
116
114    120

112    122

V$_{DD}$(+)

90

CLAMP−
SAMPLE−
AND−HOLD

OUTPUT

CLAMP (−)

SAMPLE (−)

*Fig. 9a*

Fig. 9b

Fig. 9c

POTENTIAL WELLS

(a) PULSED

(b) RAMPED

• INITIAL

• t₁

IR GENERATED

$\psi_S$(MAX)

TUNNEL GENERATED

• t₂

$\psi_S$(MAX)

$\psi_S$(MAX)

• FINAL

$\psi_S$(MAX)

$\psi_S$(MAX)

Fig.10a

Fig.10b